# EUROPEAN PATENT SPECIFICATION

(11) **EP 2 941 112 B1**
(45) Date of publication and mention of the grant of the patent: **22.03.2017**
(21) Application number: 13867223.3
(22) Date of filing: 11.04.2013
(51) Int. Cl.: H05K 13/02, B65H 19/18, B65H 21/00, B65H 20/20

(54) **SPLICING-TAPE FEED DEVICE AND FEED METHOD**
SPLEISSBAND-ZUFUHRVORRICHTUNG UND -ZUFUHRVERFAHREN
DISPOSITIF D'ACHEMINEMENT DE RUBANS D'ÉPISSAGE, ET PROCÉDÉ D'ACHEMINEMENT

(30) Priority: 27.12.2012 WO PCT/JP2012/083867
(43) Date of publication of application: 04.11.2015
(73) Proprietor: Fuji Machine Mfg. Co., Ltd., Chiryu-shi, Aichi 472-8686 (JP)
(72) Inventor: CHI Xiao Dong, Chiryu-shi Aichi 472-8686 (JP)
(74) Representative: Grünecker Patent- und Rechtsanwälte PartG mbB
(86) International application number: PCT/JP2013/060974
(87) International publication number: WO 2014/103395

(56) References cited:
- EP-A1- 0 613 339
- JP-A- 2000 038 242
- JP-A- 2002 207 286
- JP-A- 2010 120 344
- JP-A- 2011 023 723
- JP-A- 2011 233 600
- US-A1- 2004 039 480
- US-A1- 2012 317 802

## Description

### Technical Field

The present invention relates to a splicing tape feeding device and a method of feeding the same in a splicing apparatus in which two carrier tapes are automatically connected to each other.

### Background Art

Generally, in a component mounting machine, a carrier tape which retains a plurality of electronic components at regular intervals is wound around a reel and a sprocket which engages with sprocket holes bored in the carrier tape is driven so as to feed the carrier tape by a regular quantity and to sequentially supply the electronic components to a component supply position, thereby adsorbing the electronic components by a suction nozzle and mounting the electronic components in a circuit board.

In such a type of the component mounting machine, when the remaining quantity of the electronic components retained in one reel decreases, so-called splicing processing for causing a leading end portion of the carrier tape which is wound around another reel retaining the same types of the electronic components to be connected to a trailing end portion of the carrier tape of which the remaining quantity decreases is executed, by the splicing tape. PTL 1 discloses a device which includes such a splicing function.

Incidentally, in recent years, attempts have been made to perform splicing automatically. However, in order to perform splicing automatically, a splicing tape needs to be continuously fed to a splicing position where two carrier tapes are spliced. Therefore, it is effective to cause a plurality of splicing tapes to be pasted on a continuous protection tape at intervals, to feed the protection tape by a sprocket and the like, and to position the splicing tape at the splicing position.
Furthermore, the prior art in US 2012/0317802 A1 (PTL 2) refers to an electronic component mounting apparatus and an electronic component mounting method for mounting electronic components on a substrate. According to PTL 2, a tape splicing technique is adopted for splicing a carrier tape already loaded on a tape feeder to a newly loaded carrier tape, when an optical sensor has detected a joint between the already-loaded carrier tape and the newly-loaded carrier tape. A height measurement device performs measurement of a component pickup height targeted for components housed in the carrier tape in connection with the tape feeder for which the joint has been detected. Component pickup height data showing a target lowering height to which pickup nozzles are to be lowered are updated on the basis of the measurement result.

### Citation List

### Patent Literature

PTL 1: JP-A-2007-335595
PTL 2: US 2012/0317802 A1

### Summary of Invention

### Technical Problem

However, due to the nature of manufacturing a splicing tape, irregularity in pasted positions of the splicing tape inevitably occurs to some extent with respect to a protection tape. Moreover, it is difficult to accurately position the splicing tape at a splicing position due to play and the like between a sprocket and a sprocket hole which is formed in the protection tape, and thus, there is a concern that the position of the splicing tape may be misaligned and positioning errors may accumulate.

An object of the present invention is to provide a splicing tape feeding device and a method of feeding the same in which a splicing tape can be accurately positioned at a splicing position regardless of a positional error and the like of the splicing tape pasted in a protection tape.

### Solution to Problem

In order to achieve the obj ect described above, according to the invention related to Claim 1, there is provided a splicing tape feeding device in a splicing apparatus in which a first carrier tape and a second carrier tape provided with sprocket holes and component accommodation cavities at regular intervals are fed in a direction approaching each other so as to be positioned at a splicing position, and the first and second carrier tapes are connected to each other by a splicing tape at the splicing position. The splicing tape feeding device includes a plurality of the splicing tapes that are pasted at the splicing position at intervals to a continuous protection tape fed in a direction orthogonal to a feeding direction of the first and second carrier tapes and connect the first and second carrier tapes to each other, a protection tape feeding device that feeds the protection tape, a tape detection sensor that detects the splicing tape fed into a position immediately before the splicing position, and a control device that controls the protection tape feeding device so as to feed the protection tape N times by a unit distance starting from a position at which the tape detection sensor detects the splicing tape until a successive splicing tape is detected by the tape detection sensor, to feed the protection tape for a certain distance starting from a position at which the successive splicing tape is detected by the tape detection sensor, and to position the splicing tape at the splicing position.

According to the invention related to Claim 1, even though a pasted position of the splicing tape is misaligned to some extent with respect to the protection tape, it is possible to realize the splicing tape feeding device in which the splicing tape can be accurately positioned at the splicing position.

According to the invention related to Claim 2, in the splicing tape feeding device according to Claim 1, the protection tape feeding device includes a sprocket having engagement teeth which engage with the sprocket holes formed at both ends of the protection tape in a width direction and a servo motor rotating the sprocket, and returns to an original position when the servo motor starts to feed the protection tape.

According to the invention related to Claim 2, even though a position of the servo motor is misaligned while the splicing apparatus is halted, it is possible to accurately position the splicing tape at the splicing position without being affected by the misalignment.

According to the invention related to Claim 3, in the splicing tape feeding device according to Claim 2, the engagement tooth of the sprocket has a dedendum portion which engages with the sprocket hole of the protection tape while allowing no clearance therebetween and includes a pressing member which presses the protection tape so as to cause the sprocket hole of the protection tape to engage with the dedendum portion allowing no clearance therebetween.

According to the invention related to Claim 3, the engagement tooth of the sprocket and the sprocket hole of the protection tape can engage with each other by the pressing member with no play therebetween, the protection tape can be accurately fed, and the splicing tape can be accurately positioned at the splicing position.

According to the invention related to Claim 4, in the splicing tape feeding device according to any one of Claims 1 to 3, the unit distance and the certain distance are integer multiples of a pitch of the sprocket hole formed in the protection tape.

According to the invention related to Claim 4, since the unit distance and the certain distance are integer multiples of a pitch of the sprocket hole formed in the protection tape, it is possible to cause the protection tape to stop at a position where the protection tape engages with the engagement tooth of the sprocket with no play therebetween at all times.

According to the invention related to Claim 5, in the splicing tape feeding device according to any one of Claims 1 to 4, a positioning hole engaging with a positioning pin provided at the splicing position is formed in the splicing tape so as to penetrate the protection tape.

According to the invention related to Claim 5, it is possible to improve positioning accuracy for the splicing position of the splicing tape by causing the splicing tape to engage with the positioning pin provided at the splicing position.

According to the invention related to Claim 6, there is provided a method of feeding a splicing tape in a splicing apparatus in which a first carrier tape and a second carrier tape provided with sprocket holes and component accommodation cavities at regular intervals are fed in a direction approaching each other so as to be positioned at a splicing position, and the first and second carrier tapes are connected to each other by a splicing tape at the splicing position. The method of feeding a splicing tape includes feeding of a protection tape in which the splicing tape glued across the first and second carrier tapes which are positioned at the splicing position is pasted followed by feeding of a splicing tape to the position immediately before the splicing position detected by a tape detection sensor, feeding of a protection tape performed N times by a unit distance starting from the position immediately before the splicing position detected by a tape detection sensor until a successive splicing tape is detected by the tape detection sensor, and feeding of the protection tape performed thereafter for a certain distance followed by positioning of the splicing tape at the splicing position.

According to the invention related to Claim 6, even though a pasted position of the splicing tape is misaligned to some extent with respect to the protection tape, it is possible to provide the method of feeding a splicing tape in which the splicing tape can be accurately positioned at the splicing position.

### Brief Description of Drawings

[Fig. 1] Fig. 1 is a diagram illustrating a tape feeder which is suitable for executing the present invention.
[Fig. 2] Fig. 2 is a diagram illustrating a carrier tape which is retained in the tape feeder.
[Fig. 3] Fig. 3 is a cross-sectional view taken along line 3-3 in Fig. 2.
[Fig. 4] Fig. 4 is a plan view of the carrier tape which is connected by a splicing apparatus.
[Fig. 5] Fig. 5 is a perspective view illustrating the entirety of the splicing apparatus showing an embodiment of the present invention.
[Fig. 6] Fig. 6 is a diagram illustrating a state where a lid body of the splicing apparatus is open.
[Fig. 7] Fig. 7 is a diagram illustrating a state where a splicing tape is mounted in the splicing apparatus.
[Fig. 8] Fig. 8 is a diagram illustrating a supply reel around which the splicing tape used in the splicing apparatus is wound.
[Fig. 9] Fig. 9 is a diagram illustrating a state of the splicing tape which is pasted on a protection tape.
[Fig. 10] Fig. 10 is a diagram illustrating an actuation state of that in Fig. 9, that is, a state where the protection tape is fed N times by a unit distance.
[Fig. 11] Fig. 11 is a diagram illustrating another actuation state of that in Fig. 9, that is, a state where the protection tape is additionally fed for a certain distance after being fed N times by the unit distance. The diagram illustrates another state of the splicing tape which is pasted on the protection tape.
[Fig. 12] Fig. 12 is a diagram illustrating a protection tape feeding device which feeds the protection tape.
[Fig. 13] Fig. 13 is a diagram illustrating an engagement relationship between a sprocket of the protection tape feeding device and the splicing tape.
[Fig. 14] Fig. 14 is a diagram illustrating a state where a device main body and the lid body of the splicing apparatus are detached so as to expose the inside thereof.
[Fig. 15] Fig. 15 is a diagram illustrating a schematic configuration of the splicing apparatus.
[Fig. 16] Fig. 16 is a diagram of an actuation state of that in Fig. 15 illustrating a step of positioning a cutting place of the carrier tape.
[Fig. 17] Fig. 17 is a diagram of another actuation state of that in Fig. 15 illustrating a step of cutting the carrier tape at the cutting place.
[Fig. 18] Fig. 18 is a diagram of another actuation state of that in Fig. 15 illustrating a step of positioning the carrier tape with respect to a splicing position.
[Fig. 19] Fig. 19 is a perspective view illustrating a bonding device of the splicing apparatus.
[Fig. 20] Fig. 20 is a plan view illustrating the bonding device.
[Fig. 21] Fig. 21 is a front view seen in an arrow-21 direction of Fig. 20.
[Fig. 22] Fig. 22 is a right-side view seen in an arrow-22 direction of Fig. 20.
[Fig. 23] Fig. 23 is a left-side view seen in an arrow-23 direction of Fig. 20.
[Fig. 24] Fig. 24 is a diagram illustrating a closed-state retention device for closing and retaining the lid body.
[Fig. 25] Fig. 25 is a cross-sectional view illustrating a relationship between the carrier tape and the splicing tape at the splicing position.
[Fig. 26] Fig. 26(A) is a cross-sectional view taken along line 26-26 in Fig. 25, and Figs. 26(B) and 26(C) are diagrams illustrating actuation states of that in Fig. 26 (A) .
[Fig. 27] Fig. 27 is a diagram illustrating a general view of the splicing apparatus showing another embodiment of the present invention.
[Fig. 28] Fig. 28 is a diagram illustrating a photoelectric sensor which decides a cutting position of the carrier tape in another embodiment.
[Fig. 29] Fig. 29 is a diagram illustrating differences of transmitting light quantity detected by the photoelectric sensor.
[Fig. 30] Fig. 30 is a diagram illustrating types of the carrier tape.

### Description of Embodiments

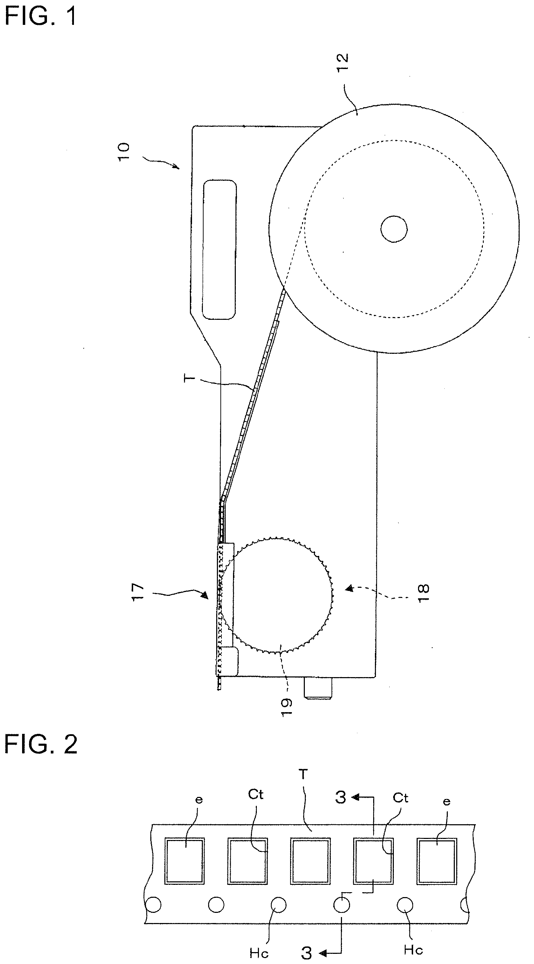

Hereinafter, an embodiment of the present invention will be described with reference to the drawings. Fig. 1 illustrates a tape feeder 10 which is detachably mounted in a component supply device of a component mounting machine. A reel 12 having a carrier tape T wound therearound is detachably attached to the tape feeder 10.

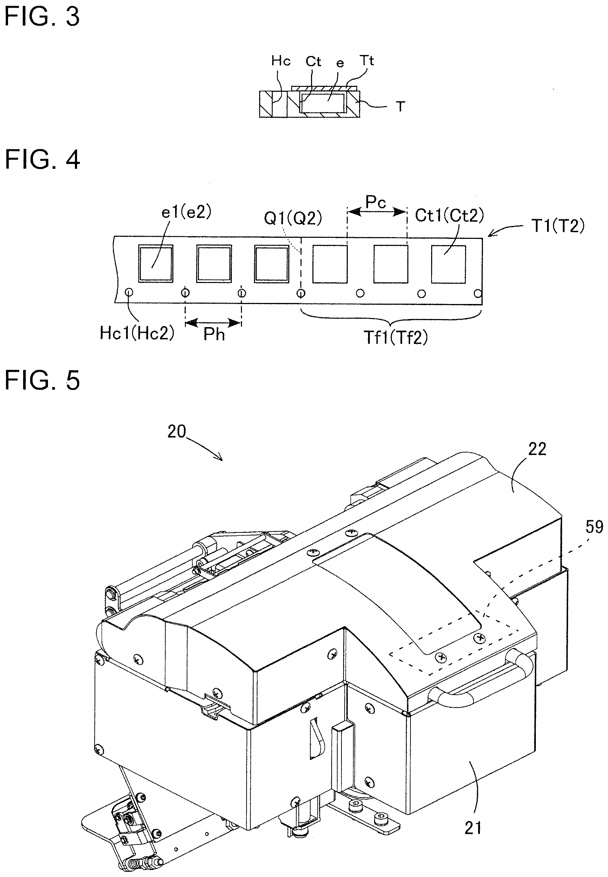

As illustrated in Figs. 2 and 3, the carrier tape T is formed in an elongated manner having a predetermined width. Multiple cavities Ct are arranged in a longitudinal direction at regular pitch intervals. Components (electronic components) e mounted in a circuit board are respectively accommodated in the cavities Ct. The upper portion of the cavity Ct is open and is covered with a top tape Tt which is pasted on the front face of the carrier tape T.

On one end side of the carrier tape T in a width direction, sprocket holes Hc are formed at the same pitch intervals as those of the cavities Ct or at pitch intervals twice those of the cavities Ct. The sprocket holes Hc are disposed in regular positional relationships with respect to the cavities Ct.

The tape feeder 10 is internally equipped with a quantitative feeding mechanism 18 quantitatively feeding the carrier tape T which is wound around the reel 12 and supplying the electronic components e one by one to component supply positions 17 which is provided at the distal end portion of the tape feeder 10. The quantitative feeding mechanism 18 includes a sprocket 19 which is rotatably supported by a main body of the tape feeder 10 and engages with the sprocket holes Hc of the carrier tape T, and a motor (not illustrated) for rotating the sprocket 19 by 1 pitch.

The carrier tapes T used in the component mounting machine are configured to be in multiple types having the pitch of the cavities Ct different from one another. Depending on the type of the carrier tape T, the pitch interval of the cavities Ct and the relationship between the cavity Ct and the sprocket hole Hc are determined. Therefore, as the pitch interval of the cavities Ct is recognized through image processing and the like, it is possible to know the type of the carrier tape T. On the basis thereof, the position of the sprocket hole Hc of the carrier tape T can be recognized, and thus, a cutting position of the carrier tape T at the time of the below-described splicing can be decided.

A splicing apparatus 20 is an apparatus which automatically connects a trailing end portion of a carrier tape wound around an existing reel mounted in the tape feeder 10 that is mounted in the component supply device to a leading end portion of a carrier tape wound around a successive reel replacing the existing reel.

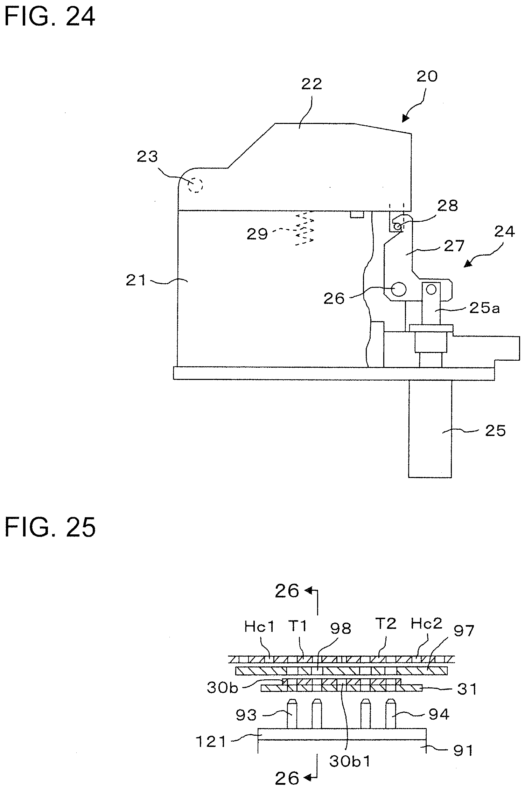

As illustrated in Fig. 5, the splicing apparatus 20 includes a box-like device main body 21 and a lid body 22 which is turnably supported by the device main body 21 centering around a pivot 23 (refer to Fig. 24) and is used for uncovering and covering the upper face of the device main body 21. The splicing apparatus 20 is configured to be loaded on a wheeled table (not illustrated) or the like so as to be movable between the tape feeders 10 mounted in the component supply device of the component mounting machine. The lid body 22 is manually placed to cover the upper face when performing splicing and is automatically moved to uncover the upper face when taking the carrier tape T out after performing splicing. When the lid body 22 covers the upper face once, the closed state is retained by a closed-state retention device described below.

In each of two carrier tapes T (hereinafter, referred to as a first carrier tape T1 and a second carrier tape T2) which is spliced by the splicing apparatus 20, as illustrated in Fig. 4, first cavities Ct1 (second cavities Ct2) accommodating first components e1 (second components e2) which are the components of the same types are provided at a predetermined pitch Pc.

In each of the first and second carrier tapes T1 and T2, first sprocket holes Hc1 (second sprocket holes Hc2) which can mesh with teeth 67a (67b) of a first sprocket 61a (a second sprocket 61b) in a first tape feeding device 50 (a second tape feeding device 51) described below are bored to be parallel to the first cavities Ct1 (the second cavities Ct2) at a predetermined pitch Ph.

The first and second carrier tapes T1 and T2 are cut at arbitrary first and second cutting places Q1 and Q2 by the splicing apparatus 20, and the cut ends thereof are caused to abut each other, thereby being connected to each other by a splicing tape 30 described below. For example, as the first cutting place Q1 (the second cutting place Q2), an intermediate position between the first cavity Ct1 (the second cavity Ct2) including the first component e1 (the second component e2) and the first vacant cavity Ct1 (the second vacant cavity Ct2) including no first component e1 (no second component e2) is selected.

The first carrier tape T1 (the second carrier tape T2) including the continuous first vacant cavities Ct1 (the continuous second vacant cavities Ct2) after being cut is discarded as a first unnecessary portion Tf1 (a second unnecessary portion Tf2). In order to secure the first vacant cavities Ct1 (the second vacant cavities Ct2) in the arbitrary numbers, an intermediate position between the first vacant cavities Ct1 (the second vacant cavities Ct2) which are adjacent to each other can be selected as the first cutting place Q1 (the second cutting place Q2).

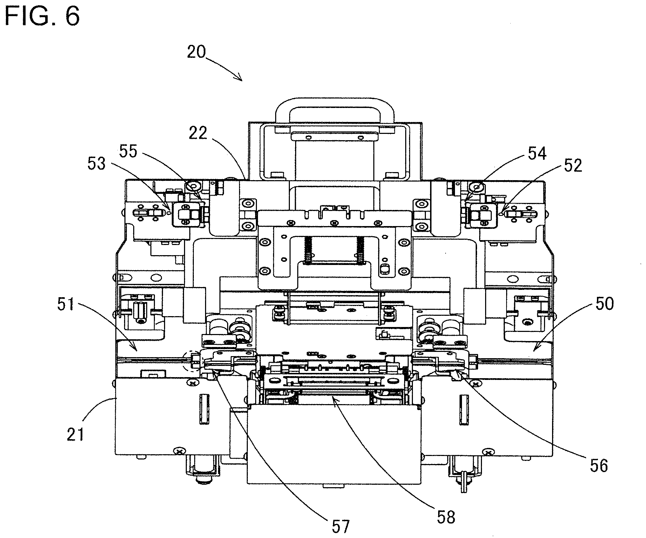

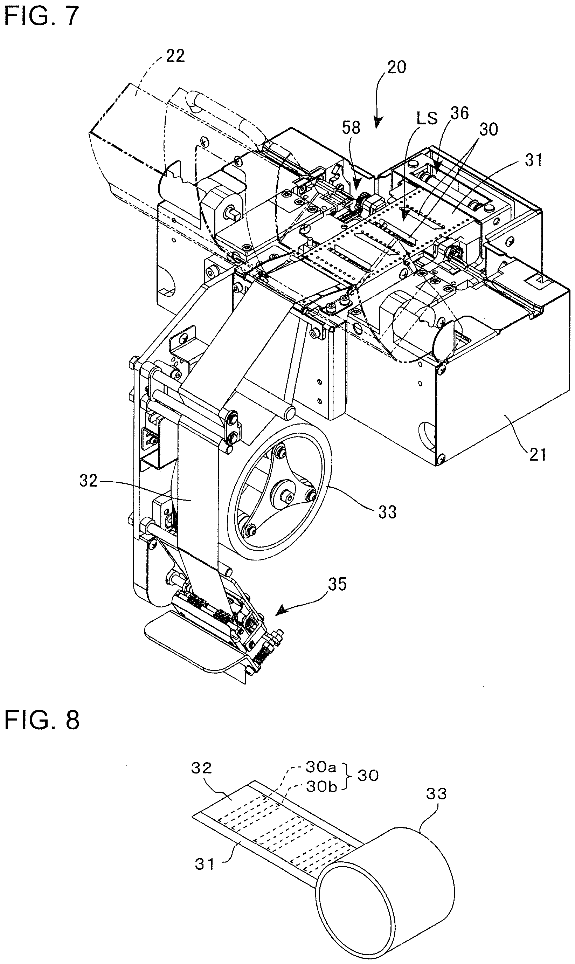

In the splicing apparatus 20, the two carrier tapes T1 and T2 to be spliced are fed from the right and left in Fig. 6, and a protection tape 31 (refer to Fig. 7) having the splicing tape 30 which connects the two carrier tapes T1 and T2 to each other pasted therein is fed from above, that is, orthogonal to the right and left in Fig. 6. Then, as illustrated in Fig. 7, end portions of the two carrier tapes T1 and T2 are connected to each other by the splicing tape 30 at a splicing position LS where the carrier tapes T1 and T2 intersect with the protection tape 31.

The splicing tape 30 pasted on the protection tape 31 is fed into the splicing position LS causing a glue face between the carrier tapes T1 and T2 to face upward, and the two carrier tapes T1 and T2 are positioned above the splicing tape 30.

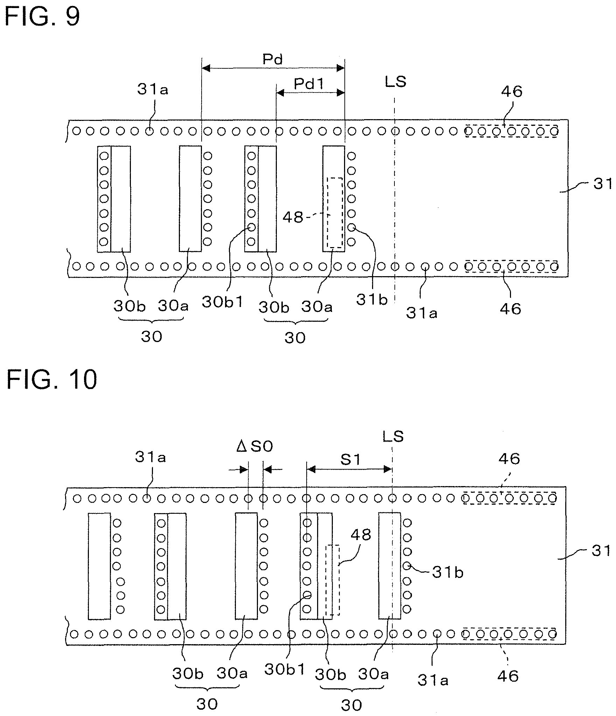

As illustrated in Fig. 9, on the upper face of the continuous protection tape 31, the splicing tape 30 is configured to include one set of splicing tapes 30a and 30b for a front face and a rear face which are glued onto both faces across the two carrier tapes T1 and T2. In other words, the splicing tape 30 is configured to form one set including the splicing tape 30a for the front face which is bonded onto the front face sides of the two carrier tapes T1 and T2 and the splicing tape 30b for the rear face which is bonded onto the rear face sides of the two carrier tapes T1 and T2.

The one set of the splicing tapes 30 for the front face and the rear face is pasted on the protection tape 31 in the longitudinal direction at regular pitch intervals Pd while maintaining a regular positional relationship with respect to sprocket holes 31a which are bored on both the sides of the protection tape 31 at regular pitch intervals. The one set of the splicing tapes 30a and 30b is disposed at predetermined intervals Pd1 causing the splicing tape 30a for the front face to be the leading side. Metal powder is embedded in the one set of the splicing tapes 30a and 30b so as to be detectable by the below-described tape detection sensor which can detect metal.

A tape detection sensor 48 for detecting the splicing tapes 30a and 30b is disposed at a predetermined position below the protection tape 31. The tape detection sensor 48 detects the splicing tapes 30a and 30b for the front face or the rear face which are fed into a predetermined position by the protection tape 31.

The upper faces of the splicing tapes 30a and 30b are formed to be adhesive faces which are glued onto both faces across the two carrier tapes T1 and T2. As illustrated in Fig. 8, a continuous paper mount 32 is glued onto the glue face thereof. A three-layer structure body including the paper mount 32, the splicing tape 30, and the protection tape 31 is wound around a supply reel 33 in a rolled manner.

The measurement of the protection tape 31 in the width direction is greater than the measurement of the paper mount 32 in the width direction, and both ends of the protection tape 31 in the width direction protrude further than both ends of the paper mount 32 in the width direction. Meanwhile, the measurement of the splicing tape 30 in the width direction is equivalent to the measurement of the paper mount 32 in the width direction, and the splicing tape 30 is pasted on the protection tape 31 forming one set with the splicing tapes for the front face and the rear face on the inner side of the sprocket hole 31a.

As illustrated in Fig. 9, a plurality of positioning holes 31b are formed in the protection tape 31 along the protection tape 31 in the width direction at the same pitch intervals as those of the sprocket holes Hc1 and Hc2 which are formed in the carrier tapes T1 and T2 at a position near the splicing tape 30a for the front face. A plurality of positioning holes 30b1 are formed so as to penetrate the protection tape 31 in the splicing tape 30b for the rear face along the protection tape 31 in the width direction at the same pitch intervals as those of the sprocket holes Hc1 and Hc2 which are formed in the carrier tapes T1 and T2.

The sprocket holes 31a and the positioning holes 31b formed in the protection tape 31 are formed through punching-pressing in association with forming of the positioning holes 30b1 performed in the splicing tape 30b after the splicing tapes 30a and 30b are pasted on the protection tape 31 at a predetermined position. Accordingly, even though a pasted position of the splicing tape 30 (30a and 30b) with respect to the protection tape 31 is misaligned or tilted to some extent, the positioning holes 30b1 formed in the splicing tape 30b can be maintained to be in a regular positional relationship with respect to the sprocket holes 31a.

As illustrated in Fig. 7, in the splicing apparatus 20, the rotatable supply reel 33 around which the three-layer structure body including the splicing tape 30 is wound in a rolled manner, a paper mount feeding device 35 which feeds the paper mount 32 peeled off from the splicing tape 30, and a protection tape feeding device 36 which feeds the protection tape 31 from which the splicing tape 30 peels off are arranged on a line crossing the splicing position LS where the two carrier tapes T1 and T2 are spliced.

Regarding a glue force of the splicing tapes 30 with respect to the paper mount 32 and the protection tape 31 which are glued onto both faces of the splicing tapes 30, the glue force with respect to the protection tape 31 is stronger than the other. Therefore, even though the paper mount 32 is caused to peel off from the splicing tape 30, the splicing tape 30 is prevented from peeling off from the protection tape 31.

However, if the carrier tapes T1 and T2 are glued onto the glue face of the splicing tape 30 from which the paper mount 32 peels off, the adhesive force thereof is stronger than the adhesive force with respect to the protection tape 31. Therefore, the protection tape 31 is likely to peel off from the splicing tape 30.

The three-layer structure body including the paper mount 32, the splicing tape 30, and the protection tape 31 is mounted in the splicing apparatus 20 in a state of being wound around the supply reel 33, and the distal end thereof is drawn out from the supply reel 33. Then, a worker causes the paper mount 32 to peel off and be folded back, and the paper mount 32 is fed by the paper mount feeding device 35 and is discarded into a paper mount accommodation box (not illustrated).

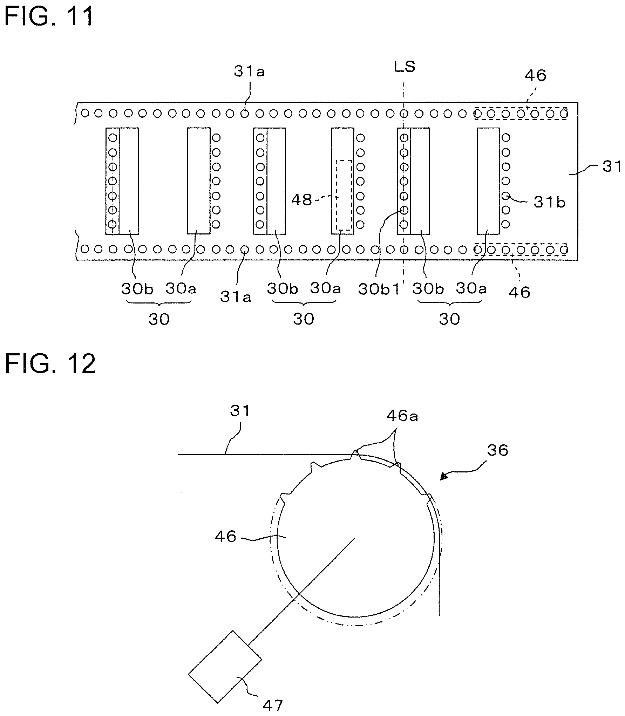

The protection tape 31 from which the paper mount 32 is peeled off, that is, the protection tape 31 in which multiple splicing tapes 30 are pasted with the glue face thereof to face upward passes through the below-described bonding device 58 so as to cross the center of the splicing position LS, and thus, the distal end portion of the protection tape 31 engages with a feeding sprocket 46 (refer to Fig. 12) of the protection tape feeding device 36.

As illustrated in Fig. 12, in the feeding sprocket 46, a plurality of engagement tooth 46a are formed at equiangular intervals in a circumferential direction at the same pitch as the pitch of the sprocket holes 31a bored in the protection tape 31. As the control device drives a stepping motor 47 connected to the feeding sprocket 46 by one pitch (corresponding to a tooth of the engagement tooth 46a), the protection tape 31 engaging with the engagement tooth 46a is fed by a unit distance ΔS0. In addition, as the below-described control device drives the stepping motor 47 by a predetermined pitch, the protection tape 31 engaging with the engagement tooth 46a is fed by a certain distance S1 (an integer multiple of the unit distance ΔS0).

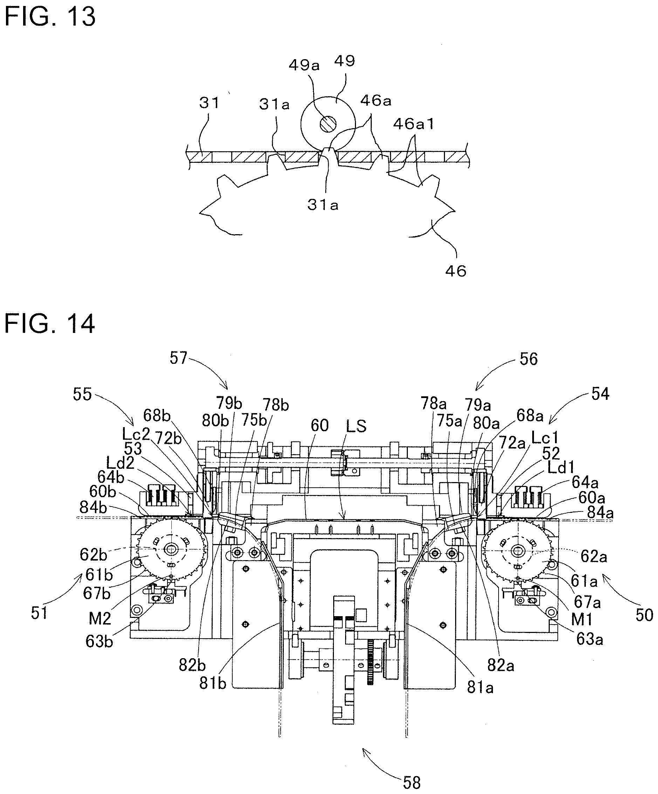

A tooth tip portion of the engagement tooth 46a in the feeding sprocket 46 is thin so as to easily engage with the sprocket holes 31a in the protection tape 31, and a dedendum portion 46a1 of the engagement tooth 46a is formed to have a rectangular shape so as to engage with the sprocket holes 31a allowing no clearance therebetween. Moreover, as illustrated in Fig. 13, a rolled pressing member 49 which presses the protection tape 31 engaging with the engagement tooth 46a positioned at the apex, so as to engage with the dedendum portion 46a1 is provided above the feeding sprocket 46.

The pressing member 49 is rotatably supported by a support shaft 49a which is supported by the device main body 21 in an elastically deformable manner, thereby being retained at a position in contact with the protection tape 31 or the splicing tape 30 at all times. In this manner, the pressing member 49 causes a sprocket hole 31a of the protection tape 31 to engage with the dedendum portion 46a1 of the engagement tooth 46a positioned at the apex, with no play therebetween, and thus, feeding accuracy of the protection tape 31 can be ensured.

The stepping motor 47 returns to the original position as power is supplied, and the engagement tooth 46a of the feeding sprocket 46 is positioned so as to be at the apex at all times. Accordingly, as the stepping motor 47 is driven by one pitch or a predetermined pitch, the sprocket hole 31a of the protection tape 31 can stop while engaging with the dedendum portion 46a1 of the engagement tooth 46a positioned at the apex, with no play therebetween.

As illustrated in Fig. 6, the splicing apparatus 20 includes the first and second tape feeding devices 50 and 51, first and second component detection devices 52 and 53, first and second cutting devices 54 and 55, first and second take-in devices 56 and 57, the bonding device 58, and a control device 59 (refer to Fig. 5). The first and second tape feeding devices 50 and 51, the first and second cutting devices 54 and 55, the first and second take-in devices 56 and 57, the bonding device 58 (excluding a portion thereof), and the control device 59 are accommodated and disposed inside the device main body 21 covered with the lid body 22.

In other words, as illustrated in Fig. 14, the first and second tape feeding devices 50 and 51 are respectively disposed on both the sides in the device main body 21 covered with the lid body 22. The first and second cutting devices 54 and 55 are respectively disposed between the first and second tape feeding devices 50 and 51. The first and second take-in devices 56 and 57 are respectively disposed between the first and second cutting devices 54 and 55. The bonding device 58 is disposed between the first and second take-in devices 56 and 57. The first and second component detection devices 52 and 53 are disposed above first and second detection positions Ld1 and Ld2 of first and second conveyance paths 60a and 60b in the first and second tape feeding devices 50 and 51.

The first and second tape feeding devices 50 and 51 include the first and second conveyance paths 60a and 60b which are provided so as to extend from both the side faces in the device main body 21 toward the center in a horizontal direction, the first and second sprockets 61a and 61b which are disposed below the first and second conveyance paths 60a and 60b, first and second stepping motors 62a and 62b which are connected to the first and second sprockets 61a and 61b, first and second sprocket tooth detection devices 63a and 63b which are disposed in the vicinity of the first and second sprockets 61a and 61b, first and second tape detection devices 64a and 64b which are disposed above the first and second conveyance paths 60a and 60b, and the like.

The first and second tape feeding devices 50 and 51 are configured to convey the first and second carrier tapes T1 and T2 along the first and second conveyance paths 60a and 60b, and to be able to position the first and second cutting places Q1 and Q2 (refer to Fig. 4) of the first and second carrier tapes T1 and T2 sequentially at first and second cutting positions Lc1 and Lc2, and the splicing position LS.

The first and second conveyance paths 60a and 60b have widths slightly greater than the widths of the first and second carrier tapes T1 and T2, and are formed to have groove shapes extending in straight lines from first and second tape entrances 84a and 84b provided on both the side faces in the device main body 21 to the first and second cutting positions Lc1 and Lc2 of the first and second carrier tapes T1 and T2 which are cut by first and second cutters 68a and 68b of the first and second cutting devices 54 and 55.

A plurality of the first and second teeth 67a and 67b are formed in the first and second sprockets 61a and 61b in the circumferential direction having the same pitch as the pitch Ph of the first and second sprocket holes Hc1 and Hc2 which are bored in the first and second carrier tapes T1 and T2. The first and second sprockets 61a and 61b are disposed below the first and second conveyance paths 60a and 60b so as to be able to mesh with the first and second sprocket holes Hc1 and Hc2 of the first and second carrier tapes T1 and T2 which are inserted along the first and second conveyance paths 60a and 60b.

The first and second sprocket tooth detection devices 63a and 63b detect that the first and second sprockets 61a and 61b are at the original positions by reading first and second marks M1 and M2 applied on the side faces of the first and second sprockets 61a and 61b.

The first and second tape detection devices 64a and 64b detect that the first and second carrier tapes T1 and T2 are inserted from the first and second tape entrances 84a and 84b provided on both the side faces in the device main body 21.

The first and second component detection devices 52 and 53 detect the first and second cavities Ct1 and Ct2 of the first and second carrier tapes T1 and T2 which are conveyed through the first and second conveyance paths 60a and 60b, a tape portion between the first and second cavities Ct1 and Ct2, and first and second components e1 and e2 inside the first and second cavities Ct1 and Ct2.

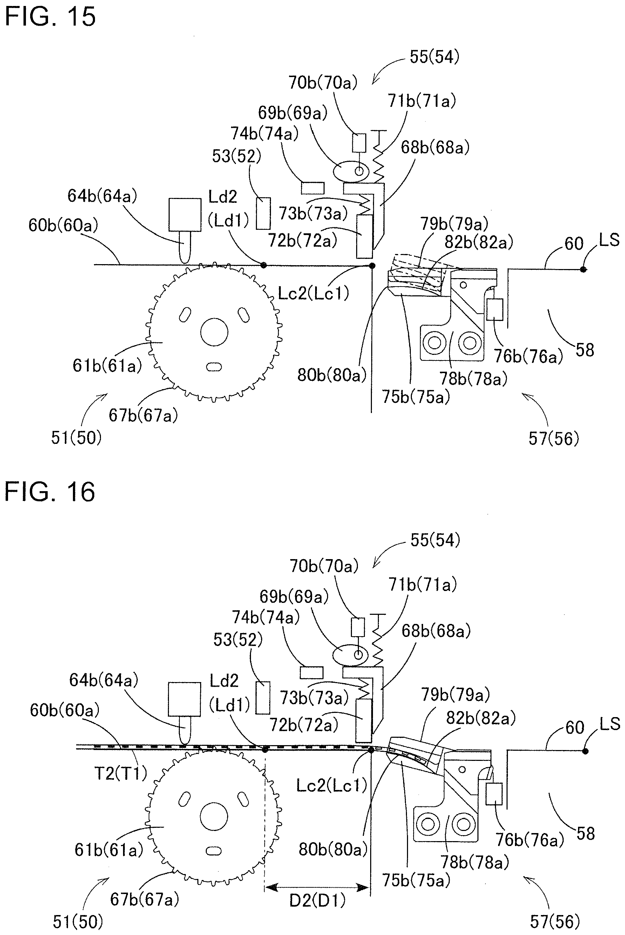

As illustrated in Figs. 14 and 15, the first and second cutting devices 54 and 55 include the first and second cutters 68a and 68b which are provided in the first and second cutting positions Lc1 and Lc2, first and second cams 69a and 69b which can come into sliding contact with the first and second cutters 68a and 68b, first and second gear motors 70a and 70b which are connectively in contact with the first and second cams 69a and 69b, first and second cutter springs 71a and 71b in which one end of each is attached to each of the first and second cutters 68a and 68b and the other end of each is attached to the inner side of the lid body 22, first and second pressing members 72a and 72b which are provided adjacent to the first and second cutters 68a and 68b, first and second pressing springs 73a and 73b in which one end of each is attached to each of the first and second cutters 68a and 68b and the other end of each is attached to each of the first and second pressing members 72a and 72b, first and second cutter detection devices 74a and 74b which are disposed in the vicinity of the first and second cutters 68a and 68b, and the like.

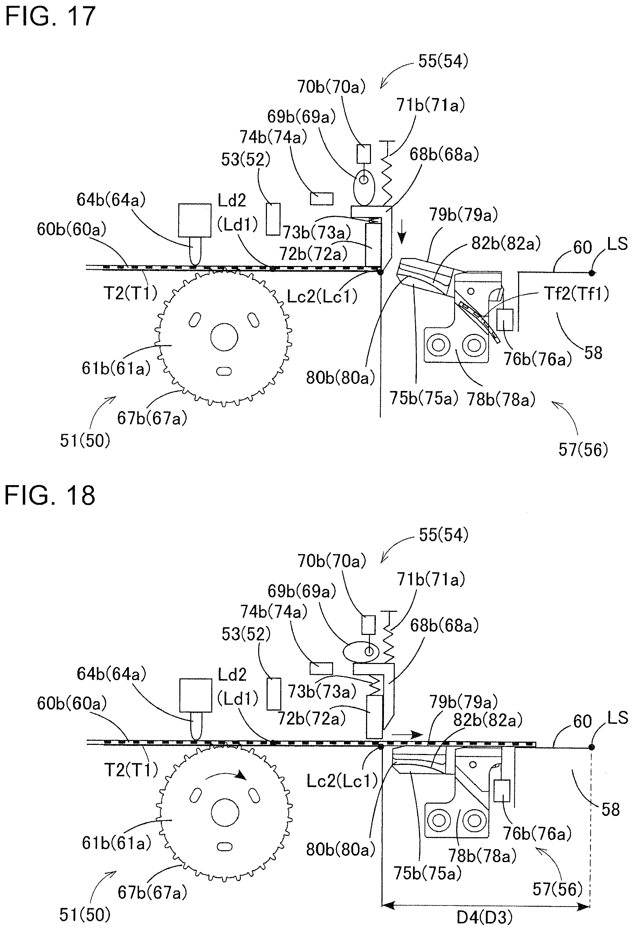

The first and second cutting devices 54 and 55 are configured to be able to cut the first and second unnecessary portions Tf1 and Tf2 (refer to Fig. 17) in the first and second cutting places Q1 and Q2 of the first and second carrier tapes T1 and T2.

In order to cut the first and second cutting places Q1 and Q2 of the first and second carrier tapes T1 and T2 which are positioned at the first and second cutting positions Lc1 and Lc2, the first and second cutters 68a and 68b are installed so as to be movable in a vertical direction, thereby moving in accordance with rotations of the first and second cams 69a and 69b.

In order to press and fix the vicinity of the first and second cutting places Q1 and Q2 of the first and second carrier tapes T1 and T2 which are positioned at the first and second cutting positions Lc1 and Lc2, the first and second pressing members 72a and 72b are provided so as to be movable in the vertical direction and are biased downward by the first and second pressing springs 73a and 73b.

The first and second take-in devices 56 and 57 are configured to include first and second take-in members 75a and 75b which are provided between the first and second cutting positions Lc1 and Lc2 and the splicing position LS and are turnably supported by first and second fixing members 78a and 78b, first and second take-in member turning devices 76a and 76b which turn the first and second take-in members 75a and 75b, and the like. The first and second take-in devices 56 and 57 are configured to be able to respectively take the cut first and second unnecessary portions Tf1 and Tf2 of the first and second carrier tapes T1 and T2.

First and second openings 80a and 80b for taking the first and second unnecessary portions Tf1 and Tf2 of the first and second carrier tapes T1 and T2 which are conveyed through the first and second conveyance paths 60a and 60b, and first and second ducts 82a and 82b for guiding the first and second unnecessary portions Tf1 and Tf2 to a dumping place (not illustrated) are formed in the first and second take-in members 75a and 75b.

While the first and second unnecessary portions Tf1 and Tf2 are taken in, the first and second take-in members 75a and 75b are retained at the original positions indicated by the dot-and-dash line in Fig. 15. When the first and second carrier tapes T1 and T2 are conveyed to the splicing position LS, as indicated by the solid line in Fig. 15, the first and second take-in member turning devices 76a and 76b turn the first and second take-in members 75a and 75b by a predetermined angle so as to cause first and second movable conveyance paths 79a and 79b formed in the first and second take-in members 75a and 75b to be aligned with the first and second conveyance paths 60a and 60b.

The bonding device 58 is provided between the first cutting device 54 and the second cutting device 55. The bonding device 58 is configured to be able to connect the first and second carrier tapes T1 and T2 to each other at the splicing position LS in the middle of the first and second conveyance paths 60a and 60b where the first and second cutting places Q1 and Q2 are caused to abut each other, by using the splicing tape 30.

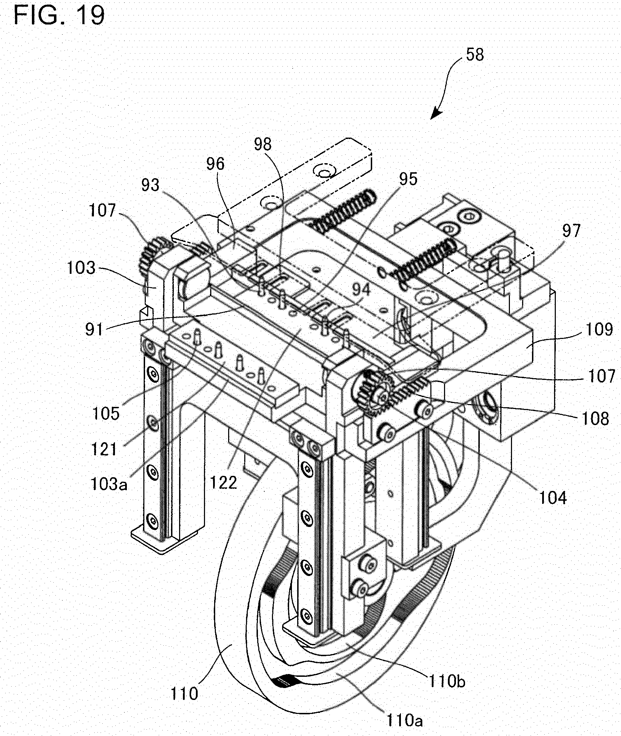

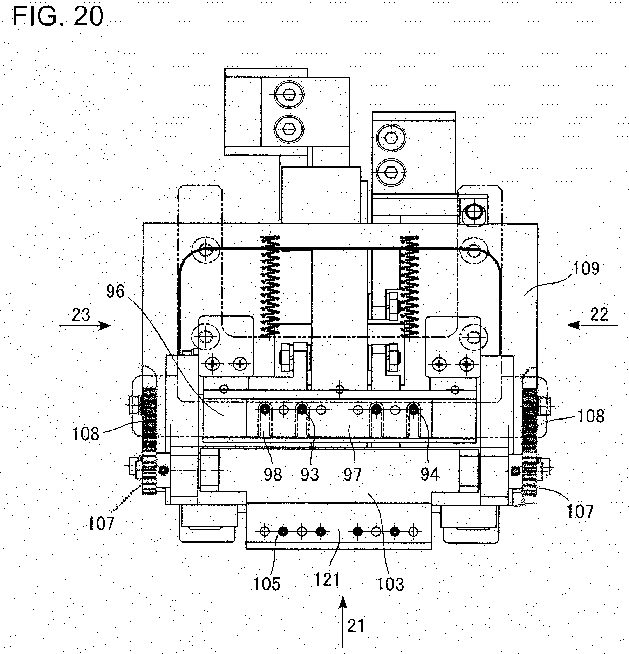

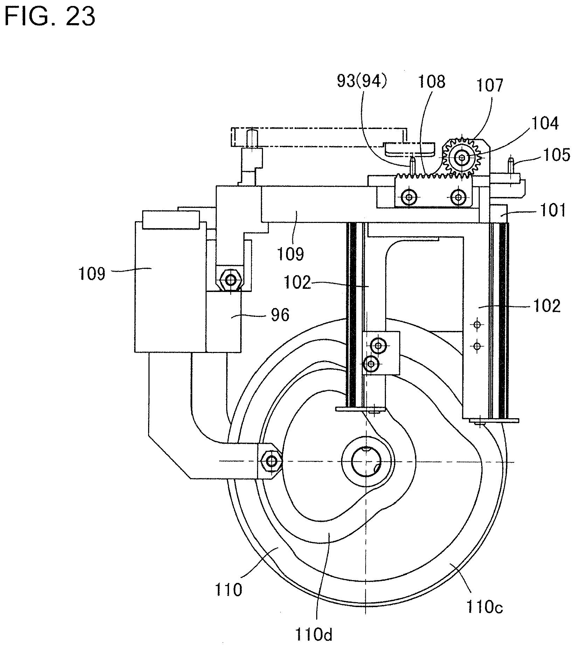

Subsequently, the configuration of the bonding device 58 will be described with reference to Figs. 19 to 23. The bonding device 58 includes a first lifting and lowering table 91, a pressing plate 97, a second lifting and lowering table 101, a swivel table 103, and the like. Leg portions 92 of the first lifting and lowering table 91 are guided and supported by the device main body 21 so as to be able to be lifted and lowered. On the first lifting and lowering table 91, two for each of first positioning pins 93 and 94 which can engage with the positioning holes 30b1 formed in the splicing tape 30b, and each of the sprocket holes Hc of the two carrier tapes T1 and T2 are provided protruding along the carrier tapes T1 and T2 in a feeding direction on both the sides having a bonding position (an abutting position) of the two carrier tapes T1 and T2 as the center. Each pitch of the two sets of the first positioning pins 93 and 94 is set to be twice the pitch Ph of the sprocket holes Hc in the carrier tapes T1 and T2.

In the first lifting and lowering table 91, a pin hole 95 is formed between each set of the first positioning pins 93 and 94, and second positioning pins 105 on the below-described swivel table 103 side can be inserted into the pin holes 95.

A movable table 96 is movably guided and supported by the device main body 21 in the horizontal direction orthogonal to the longitudinal direction of the carrier tapes T1 and T2. The pressing plate 97 is attached to the movable table 96 at a position above the first positioning pins 93 and 94. U-shaped grooves 98 which can accommodate the first positioning pins 93 and 94 are formed at the distal end of the pressing plate 97. The pressing plate 97 can move forward and rearward between positions of a rearward movement end at which the grooves 98 escape from the first positioning pins 93 and 94 and a forward movement end at which the grooves 98 accommodate the first positioning pins 93 and 94.

Moreover, leg portions 102 of the second lifting and lowering table 101 are guided and supported by the device main body 21 so as to be able to be lifted and lowered. On the second lifting and lowering table 101, both ends of the swivel table 103 are supported having a pivot shaft 104 which is parallel to the longitudinal direction of the carrier tapes T1 and T2 as the swivel center, so as to be swivelable 180 degrees. A pressing plate 103a is provided in the swivel table 103 at a position offset from the swivel center. A plurality of the second positioning pins 105 and pin holes 106 are provided in the pressing plate 103a. Each of the second positioning pins 105 is arranged at a position corresponding to the middle of the first positioning pins 93 and 94 which are provided on the first lifting and lowering table 91, and is able to be inserted into the pin hole 95 which is provided in the first lifting and lowering table 91. Moreover, each of the pin holes 106 is arranged at a position corresponding to the middle of the second positioning pins 105, and the first positioning pins 93 and 94 which are provided on the first lifting and lowering table 91 can be inserted therein.

As the swivel table 103 swivels 180 degrees, the second positioning pins 105 engage with the sprocket holes Hc of the two carrier tapes T1 and T2 which are positioned at the splicing position LS and the positioning holes 30b1 of the splicing tape 30b so that positional relationships are regularly maintained among the three, that is, the two carrier tapes T1 and T2 and the splicing tape 30 which connects the two carrier tapes T1 and T2 to each other.

Pinions 107 are attached to the pivot shaft 104 of the swivel table 103, and racks 108 which mesh with the pinions 107 are attached to a movable table 109 which is movable in the horizontal direction orthogonal to a conveyance direction of the carrier tapes T1 and T2. Accordingly, as the movable table 109 moves, the swivel table 103 is caused to swivel by rack and pinion mechanisms each of which includes the pinion 107 and the rack 108.

As the swivel table 103 swivels, the three of the two carrier tapes T1 and T2 and the splicing tape 30 are pinched between the pressing plate 103a and the first lifting and lowering table 91, thereby being connected to one another.

A cam drum 110 is rotatably supported in the device main body 21 around the axial line which is parallel to the swivel center of the swivel table 103, thereby rotating slowly in a regular direction by a drive motor (not illustrated). On both the faces of the cam drum 110, two sets of inner and outer cam grooves 110a and 110b, and 110c and 110d are respectively and endlessly formed in the circumferential direction.

A first follower roller (not illustrated) which is pivotally supported by the leg portions 92 of the first lifting and lowering table 91 engages with the first cam groove 110a. A second follower roller (not illustrated) which is pivotally supported by the movable table 96 connected to the pressing plate 97 engages with the second cam groove 110b. A third follower roller (not illustrated) which is pivotally supported by the leg portions 102 of the second lifting and lowering table 101 engages with the third cam groove 110c. A fourth follower roller (not illustrated) which is pivotally supported by a connection member 112 connected to the movable table 109 engages with the fourth cam groove 110d.

In this manner, as the cam drum 110 rotates, a lifting and lowering motion of each of the first and second lifting and lowering tables 91 and 101, a forward and rearward motion of the pressing plate 97, and a swivel motion of the swivel table 103 are inter-connectedly performed through the first to fourth follower rollers which respectively engage with the first to fourth cam grooves 110a to 110d. The first and second lifting and lowering tables 91 and 101, the pressing plate 97, and the swivel table 103 return to the original positions with one rotation of the cam drum 110.

As illustrated in Fig. 24, the splicing apparatus 20 is provided with a closed-state retention device 24 which retains the lid body 22 in a closed state during a splicing operation. The closed-state retention device 24 is mainly configured to include a solenoid 25 which is installed in the device main body 21 and is able to actuate an actuation rod 25a in the vertical direction, a hook 27 which is turnably supported by the device main body 21 centering around a spindle 26 and is caused to turn by the solenoid 25, and an engagement pin 28 which is provided in the lid body 22 so as to protrude downward and disengageably engages with the hook 27.

An opening spring 29 which biases the lid body 22 in an opening direction is provided between the device main body 21 and the lid body 22. When the hook 27 is caused to disengage from the engagement pin 28, the lid body 22 is automatically moved by the opening spring 29 so as to uncover the inside. A dog (not illustrated) is provided in the lid body 22, and the device main body 21 is provided with a closed-state confirmation sensor which is operated by the dog. The closed-state confirmation sensor is operated by the dog when covering the inside with the lid body 22, and a closed state of the lid body 22 is confirmed based on an ON signal of the closed-state confirmation sensor.

Then, when the lid body 22 is placed to cover the inside by a worker and the closed-state confirmation sensor is turned on by the dog, the actuation rod 25a of the solenoid 25 is actuated in the upward direction of Fig. 24 and the hook 27 is caused to turn so as to engage with the engagement pin 28, based on the ON signal. Accordingly, the lid body 22 is retained in a closed state by the closed-state retention device 24.

When the two carrier tapes T1 and T2 are connected to each other by the splicing tape 30 and a connection completion signal is issued by the control device 59, the actuation rod 25a of the solenoid 25 is actuated in the downward direction of Fig. 24. Accordingly, the hook 27 is caused to turn so as to disengage from the engagement pin 28, and the lid body 22 is automatically moved to uncover the inside due to a biasing force of the opening spring 29.

Subsequently, an operation of the splicing apparatus 20 according to the above-described embodiment will be described. When the remaining quantity of the components e retained in the first carrier tape T1 which is wound around the reel 12 attached to the tape feeder 10 decreases, splicing processing for causing the leading end portion of the second carrier tape T2 which is wound around another reel accommodating the same types of the components e to be connected to the trailing end portion of the first carrier tape T1 is executed by the splicing tape 30. The components can be reloaded through such splicing processing, and thus, the tape feeder 10 can continue to supply the components.

In such splicing processing, so-called verifying of splicing processing is generally executed in order to check whether or not the carrier tape accommodating the right components is connected thereto. In verifying of splicing processing, a barcode labelled on an old reel is read by a barcode reader, and the serial ID of the components accommodated in the old reel is transmitted to a management computer. Subsequently, a barcode labelled on a new reel is read by the barcode reader, and the serial ID of the components accommodated in the new reel is transmitted to the management computer.

Since data related to the component is stored in the database of the management computer for each serial ID, it is possible to verify whether or not the components accommodated in the two carrier tapes T1 and T2 are the same types by the read serial IDs. If the components are inconsistent with each other, a verification error is displayed on an operation panel and an operator is notified, and thus, the operator restarts splicing processing based thereon.

When verifying of splicing processing is completed, each end portion of the two carrier tapes T1 and T2 is cut with scissors. At this time, generally, since a vacant cavity portion having no component accommodated therein is provided at the end portion of each of the carrier tapes T1 and T2 to the extent of several tens of millimeters, the portion is cut by a worker. In this case, as is obvious from the following description, since the cut faces are not the abutting faces of the two carrier tapes T1 and T2, accuracy is not particularly required.

Generally, the lid body 22 is placed to cover the inside thereof. When a worker turns the power on in the state thereof, the control device 59 causes the stepping motors 62a and 62b to return to the original positions, based on detection signals from the first and second sprocket tooth detection devices 63a and 63b. In such a state, the control device 59 detects whether or not the distal end portions of the first and second tapes T1 and T2 are inserted from the first and second tape entrances 84a and 84b, based on detection signals from the first and second tape detection devices 64a and 64b. When it is detected that the distal end portions of the first and second tapes T1 and T2 are inserted, the stepping motors 62a and 62b start so as to rotate the first and second sprockets 61a and 61b, and cause movable members 77a and 77b of the first and second take-in members 75a and 75b to move upward.

Subsequently, the control device 59 sequentially detects the first vacant cavities Ct1 and Ct2, and the second vacant cavities Ct1 and Ct2 which do not include the components e1 and e2 in the first and second tapes T1 and T2 , based on detection signals from the first and second tape detection devices 64a and 64b, thereby calculating the pitch Pc between the cavities Ct1 and Ct2 based on the detection of the first and second cavities Ct1 and Ct2.

Subsequently, the control device 59 calculates the cutting places Q1 and Q2 (refer to Fig. 4) of the first and second tapes T1 and T2 based on the pitch Pc between the cavities Ct1 and Ct2, and distances D1 and D2 between the known detection positions Ld1 and Ld2 and the known cutting positions Lc1 and Lc2. Then, as illustrated in Fig. 16, the first and second tapes T1 and T2 are moved by the distances D1 and D2, and the unnecessary portions Tf1 and Tf2 are taken in the first and second take-in members 75a and 75b, thereby conveying and positioning the cutting places Q1 and Q2 to the cutting positions Lc1 and Lc2.

In this manner, when conveying and positioning of the first and second carrier tapes T1 and T2 are completed, the control device 59 causes each of the cutters 68a and 68b to be lowered together with the pressing members 72a and 72b so as to press and fix the vicinity of the cutting places Q1 and Q2 of the first and second carrier tapes T1 and T2 which are positioned at the cutting positions Lc1 and Lc2, by using the pressing members 72a and 72b. Successively, each of the cutters 68a and 68b is lowered so as to cut each of the cutting places Q1 and Q2 of the first and second carrier tapes T1 and T2. The unnecessary portions Tf1 and Tf2 cut off from the first and second carrier tapes T1 and T2 are guided into the ducts 82a and 82b of the take-in members 75a and 75b, thereby being discarded.

As the first and second carrier tapes T1 and T2 are cut by the cutters 68a and 68b, the control device 59 causes the take-in members 75a and 75b to move downward. Thereafter, each of the sprockets 61a and 61b is caused to rotate by the stepping motors 62a and 62b, and the first and second carrier tapes T1 and T2 are moved respectively by the known distances D3 and D4 from the cutting positions Lc1 and Lc2 to the splicing position LS, thereby conveying and positioning the cutting places Q1 and Q2 of the first and second carrier tapes T1 and T2 at the splicing position LS. Accordingly, the sprocket holes Hc1 and Hc2 of the first and second carrier tapes T1 and T2 are positioned at positions so as to be able to engage with the first positioning pins 93 and 94 of the bonding device 58 provided at the splicing position LS.

In this manner, the distal ends of the first and second carrier tapes T1 and T2 inserted from the first and second tape entrances 84a and 84b are positioned at the splicing position LS without causing a misaligned pitch.

Meanwhile, the three-layer structure body including the paper mount 32, the splicing tape 30, and the protection tape 31 wound around the supply reel 33 is drawn out from the supply reel 33, and the paper mount 32 is caused to peel off, thereby being fed by the paper mount feeding device 35. The protection tape 31 having the splicing tape 30 pasted thereto is fed by the protection tape feeding device 36, and thus, one set of the splicing tapes 30 for the front face and the rear face is conveyed to the splicing position LS.

In other words, the splicing tape 30 is fed to a position where the tape detection sensor 48 is turned on due to the splicing tape 30a for the front face, by the stepping motor 47 of the protection tape feeding device 36, and the splicing tape 30 temporarily stops there. In this case, the position of the splicing tape 30a for the front face which is detected by the tape detection sensor 48 may be roughly obtained as long as the position is within a range which can be detected by the tape detection sensor 48. Therefore, there is no problem even though the splicing tape 30 (30a and 30b) is pasted at a position which is misaligned to some extent from a proper position with respect to the sprocket hole 31a of the protection tape 31.

Immediately after the protection tape 31 is set to the splicing apparatus 20, the protection tape feeding device 36 feeds the protection tape 31 until a first splicing tape 30a for the front face is detected by the tape detection sensor 48. Meanwhile, when the splicing tape 30a for the front face cannot be detected by the tape detection sensor 48 even though a predetermined length of the protection tape 31 is fed by the protection tape feeding device 36, a splicing tape disconnection signal is issued by the control device 59, and a worker is notified so as to prepare a new protection tape 31.

If the protection tape 31 stops at the position where the tape detection sensor 48 is turned on due to the splicing tape 30a for the front face, the control device 59 subsequently supplies power to the stepping motor 47 on a condition that the tape detection sensor 48 is turned on. As the power is supplied, the stepping motor 47 returns to the original position, and the feeding sprocket 46 is positioned at the position where the engagement tooth 46a is positioned at the apex. In such a state, the stepping motor 47 starts to rotate, and the protection tape 31 is intermittently fed by the unit distance ΔS0. Every time the protection tape 31 is intermittently fed by the unit distance ΔS0, the control device 59 monitors whether or not the tape detection sensor 48 is turned on by a successive splicing tape 30a for the front face. Then, the protection tape 31 is intermittently fed for N times until the tape detection sensor 48 is turned on due to the splicing tape 30b for the rear face.

While the protection tape 31 is intermittently fed, when the tape detection sensor 48 is turned on due to the splicing tape 30b for the rear face, the positioning holes 30b1 formed in the splicing tape 30b for the rear face are positioned at a position away from the splicing position LS by the certain distance (SO), that is, a position away from the splicing position LS by an integer multiple of the pitch of the sprocket holes 31a.

In this case, since the pressing member 49 causes the sprocket hole 31a of the protection tape 31 to engage with the engagement tooth 46a which is positioned at the apex, with no play therebetween, and accuracy in stopping can be ensured, even though the pasted position of the splicing tape 30 is misaligned to some extent with respect to the protection tape 31, the positioning holes 30b1 formed in the splicing tape 30b for the rear face are accurately positioned at the position away from the splicing position LS by the certain distance (S0), that is, a position corresponding to an integer multiple of the pitch of the sprocket holes 31a.

While the protection tape 31 is intermittently fed, when the tape detection sensor 48 is turned on due to the splicing tape 30a for the front face, the stepping motor 47 successively causes the feeding sprocket 46 to rotate by a predetermined pitch (corresponding to a predetermined number of the teeth) from the state where the engagement tooth 46a is positioned at the apex. Accordingly, the protection tape 31 is fed for the certain distance (an integer multiple of the distance between the sprocket holes 31a) S1, thereby being accurately positioned at the splicing position LS where the splicing tape 30b for the rear face can engage with the positioning pins 93 and 94 (refer to Fig. 25). In this case as well, similarly to the above-described case, the pressing member 49 causes the sprocket hole 31a of the protection tape 31 to engage with the engagement tooth 46a which is positioned at the apex, with no play therebetween, and accuracy in stopping can be ensured.

In this manner, in a state where the sprocket hole 31a of the protection tape 31 engages with the engagement tooth 46a of the feeding sprocket 46 with no play therebetween, since the stepping motor 47 feeds the protection tape 31 from the apex of the engagement tooth 46a to another apex by the unit distance ΔS0 for N times and additionally feeds the protection tape 31 for the certain distance S1, even though the pasted position of the splicing tape 30 is misaligned with respect to the sprocket hole 31a of the protection tape 31, the splicing tape 30 can be accurately positioned at the splicing position LS.

When the splicing tape 30 is positioned at the splicing position LS, if the first and second carrier tapes T1 and T2 are not positioned at the splicing position LS, the splicing tape 30 is on standby until the first and second carrier tapes T1 and T2 are positioned at the splicing position LS.

As each of the first and second carrier tapes T1 and T2, and the splicing tape 30 is positioned at the splicing position LS, the drive motor (not illustrated) rotates the cam drum 110. Firstly, in accordance with rotations of the cam drum 110, the first lifting and lowering table 91 rises through the first follower roller (not illustrated) which engages with the first cam groove 110a.

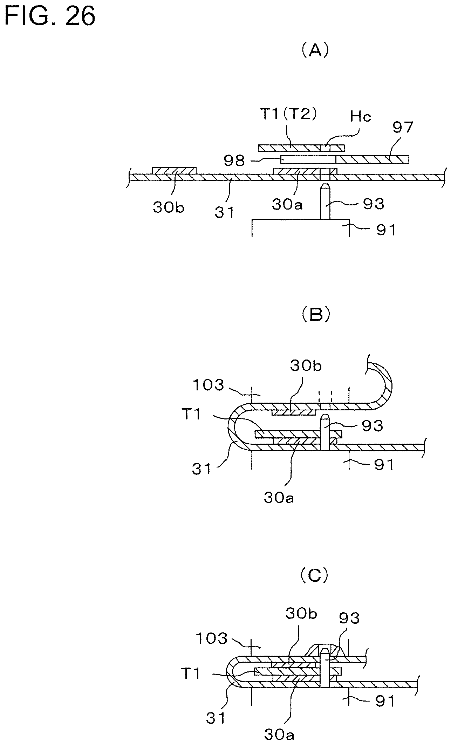

As the first lifting and lowering table 91 rises, the first positioning pins 93 and 94 respectively engage with the positioning holes 30b1 in the splicing tape 30b for the rear face and each of the sprocket holes Hc in the two carrier tapes T1 and T2. At this time, as illustrated in Fig. 26(A), since the pressing plate 97 is interposed between the splicing tape 30b for the rear face and each of the carrier tapes T1 and T2, the carrier tapes T1 and T2 are unlikely to be glued onto the splicing tape 30b for the rear face. Accordingly, the positional relationships among the three, that is, the two carrier tapes T1 and T2 and the splicing tape 30b for the rear face which is glued onto the rear face sides of the two carrier tapes T1 and T2 can be regularly maintained.

Subsequently, the movable table 96 moves in the horizontal direction through the second follower roller (not illustrated) which engages with the second cam groove 110b. The pressing plate 97 which is interposed between the splicing tape 30b for the rear face and the carrier tapes T1 and T2 moves rearward with respect to the first lifting and lowering table 91. Thus, the splicing tape 30b for the rear face can be glued onto the carrier tapes T1 and T2.

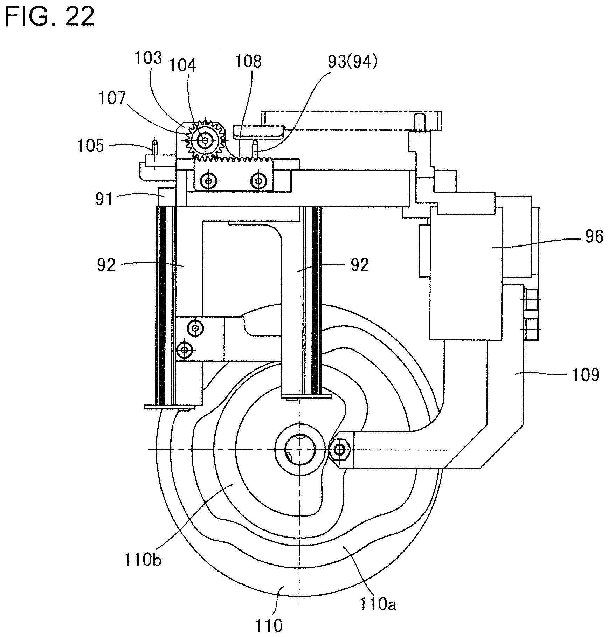

Subsequently, the movable table 109 moves horizontally through the third follower roller (not illustrated) which engages with the third cam groove 110c. In accordance with the horizontal movement of the movable table 109, the swivel table 103 swivels in the clockwise direction of Fig. 22 by the rack and pinion mechanism (107 and 108). In accordance with swiveling of the swivel table 103, as illustrated in Fig. 26(B), the protection tape 31 engaging with the second positioning pins 105 is bent, and the splicing tape 30a for the front face is turned over with the glue face to face downward at a position above the carrier tapes T1 and T2. In other words, the protection tape 31 is bent so as to clamp the carrier tapes T1 and T2 therebetween. Then, the splicing tape 30b for the rear face is positioned on the rear face sides of the carrier tapes T1 and T2, and the splicing tape 30a for the front face is positioned on the front face sides of the carrier tapes T1 and T2. At this time, the motor of the protection tape feeding device 36 rotates reversely so as to impart slackness to the protection tape 31, thereby allowing the protection tape 31 to be bent.

Successively, the second lifting and lowering table 101 is lowered through the fourth follower roller (not illustrated) which engages with the fourth cam groove 110d. As the second lifting and lowering table 101 is lowered, as illustrated in Fig. 26(C), the second positioning pins 105 engage with the positioning holes 31b of the protection tape 31, the sprocket holes Hc of the carrier tapes T1 and T2, and the positioning holes 30b1 of the splicing tape 30b for the rear face from the rear side of the protection tape 31.

Moreover, as the second lifting and lowering table 101 is lowered, in a state of pinching the carrier tapes T1 and T2, the bent protection tape 31 is pressed between the pressing plate 103a of the swivel table 103 and the first lifting and lowering table 91. Due to the pressing, the splicing tape 30b for the rear face pasted on the protection tape 31 is glued across the rear faces of the carrier tapes T1 and T2, and the splicing tape 30a for the front face is glued across each of the top tapes Tt which are pasted on the front faces of the carrier tapes T1 and T2. Thus, the trailing end portion of the first carrier tape T1 and the leading end portion of the second carrier tape T2 are connected to each other. The pressed state lasts for a certain time (for several seconds).

Since the two carrier tapes T1 and T2 are connected by the splicing tape 30 in a state where the carrier tapes T1 and T2 and the splicing tapes 30a and 30b are restricted in relative misalignment by the first and second positioning pins 93, 94, and 105, the two carrier tapes T1 and T2 can be accurately bonded without causing misalignment of the pitch.

Bonding of the two carrier tapes T1 and T2 performed by the splicing tape 30 is achieved in accordance with the 180-degree rotation of the cam drum 110, and each of the constituting members return to the original position in accordance with the remaining 180-degree rotation due to an operation opposite to that described above.

In other words, the second lifting and lowering table 101 rises first, and the swivel table 103 rises with respect to the first lifting and lowering table 91. Then, the pressed state of the bent protection tape 31 is released, and the second positioning pins 105 escape from the positioning holes 30b1 of the splicing tape 30b for the rear face and each of the sprocket holes Hc of the two carrier tapes T1 and T2.

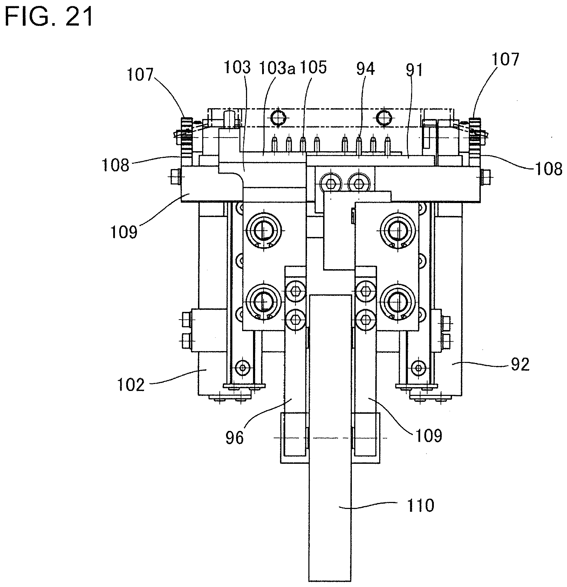

Successively, the swivel table 103 swivels in the counterclockwise direction of Fig. 21 through the rack and pinion mechanism (108 and 107), and the motor of the protection tape feeding device 36 rotates forward, thereby eliminating the slackness of the protection tape 31.

Thereafter, the pressing plate 97 moves forward, and the first lifting and lowering table 91 is lowered. Then, the first positioning pins 93 and 94 escape from the positioning holes 30b1 of the splicing tape 30b for the rear face and each of the sprocket holes Hc of the two carrier tapes T1 and T2. Meanwhile, the motor is driven in the paper mount feeding device 35 so as to apply tension to the paper mount 32, and thus, the paper mount 32 peels off as much as necessary. In this manner, bonding between the trailing end portion of the first carrier tape T1 and the leading end portion of the second carrier tape T2 is completed.

In this manner, as the two carrier tapes T1 and T2 are connected to each other by the splicing tape 30, a connection completion signal is issued by the control device 59. Based on the connection completion signal, the solenoid 25 of the splicing apparatus 20 is actuated, the actuation rod 25a moves downward, and the hook 27 turns in the clockwise direction of Fig. 24 centering around the spindle 26. Accordingly, the hook 27 and the engagement pin 28 are disengaged from each other, and the lid body 22 turns centering around the pivot 23 by the biasing force of the spring 29, thereby automatically uncovering the inside thereof. In such a state, the carrier tapes T1 and T2 connected to each other by the splicing tape 30 are taken out from the inside of the splicing apparatus 20 by a worker.

When the carrier tapes T1 and T2 are taken out from the inside of the splicing apparatus 20, since the splicing tape 30 has high adhesiveness with respect to the carrier tapes T1 and T2, the protection tape 31 easily peels off from the splicing tape 30 due to a returning force of the spring of the protection tape 31 generated by releasing the pressed state of the protection tape 31, and thus, the splicing tape 30 is unlikely to peel off from the carrier tapes T1 and T2.

Thereafter, the reel 12 having the second carrier tape T2 wound therearound is set to the tape feeder 10, thereby completing splicing processing. In this manner, the tape feeder 10 is reloaded with the components, and thus, mounting of the components can be continuously carried out in the component mounting machine without stopping the machine.

When the lid body 22 is placed to cover the inside by a worker in order to splice another carrier tape, the closed-state confirmation sensor (not illustrated) is turned on by the dog which is fixed onto the lid body 22. Based on the ON signal of the closed-state confirmation sensor, the solenoid 25 is actuated, and the actuation rod 25a moves upward. Accordingly, the hook 27 turns in the counterclockwise direction of Fig. 24 centering around the spindle 26, thereby engaging with the engagement pin 28 fixed onto the lid body 22. At the same time, an actuation confirmation sensor (not illustrated) is turned on by the dog (not illustrated) attached to the hook 27. As both of the closed-state confirmation sensor and the actuation confirmation sensor are turned on, the splicing apparatus 20 can be automatically operated.

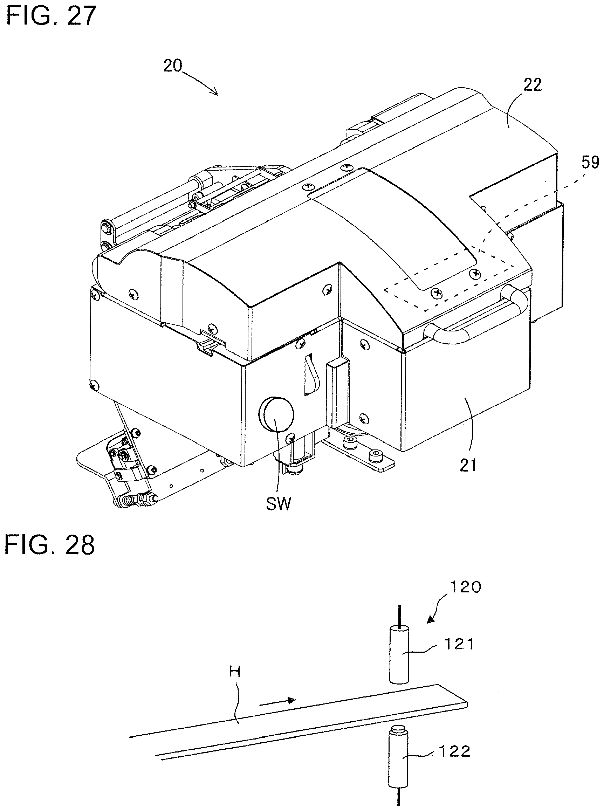

Figs. 27 to 30 illustrate another embodiment of the present invention in which when the carrier tapes T1 and T2 are cut at predetermined positions prior to splicing, the pitch of the cavities Ct and a starting position of the electronic component e are detected by using a photoelectric sensor 120 which is inexpensive and small, thereby deciding the cutting positions thereof.

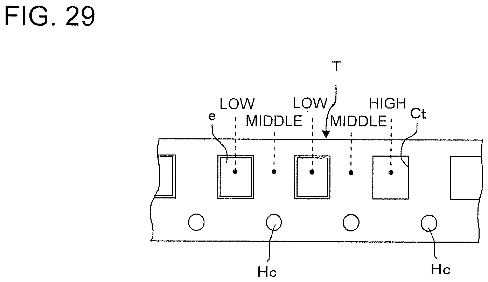

As illustrated in Fig. 28, the photoelectric sensor 120 is configured to include a projector 121 and a photodetector 122 which are disposed interposing the carrier tape T therebetween. The photoelectric sensor 120 is installed on each side of the first and second carrier tapes T1 and T2 which are connected to each other by the splicing tape 30 (refer to Fig. 9). The photoelectric sensor 120 detects the vacant cavity portion of the carrier tape T, the paper portion, and the cavity portion including a component based on the differences of transmitting light quantity. In other words, as illustrated in Fig. 29, when the cavity portion Ct is vacant having no component e, the transmitting light quantity is high. When the cavity portion Ct includes a component having the component e accommodated therein, the transmitting light quantity is low. When it is the paper portion, the transmitting light quantity is intermediate therebetween.

Therefore, if a suitable threshold value is set depending on the transmitting light quantity, the vacant cavity portion of the carrier tape T, the paper portion, and the cavity portion including a component can be identified, and the pitch of the cavities and the starting position of the component of the carrier tape T can be automatically determined. Therefore, similarly to the above-described embodiment, the cutting position of the carrier tape T can be decided.

Incidentally, since there are various types of the carrier tapes T, the pitch of the cavities and the starting position of the component of the carrier tape T may not be detected by the method of setting a threshold value. The following are examples of carrier tapes: (1) a carrier tape of which the cavity portion including a component cannot be discriminated due to the extremely small component, (2) a carrier tape having no vacant cavity (in use), (3) a carrier tape of a semitransparent embossed type having low opacity, or a carrier tape of an embossed type having no opacity. It is not possible to identify the vacant cavity portion of the carrier tape T, the cavity portion including a component, and the like only by the transmitting light quantity. There is a carrier tape which cannot automatically discriminate the pitch of the cavities and the starting position of the component of the carrier tape.

Therefore, in order to discriminate the vacant cavity portion, the paper portion, and the cavity portion including a component using the photoelectric sensor 120 based on differences of the transmitting light quantity, the carrier tapes which can be automatically discriminated and the carrier tape which cannot be automatically discriminated need to be classified when in use.

Here, according to another embodiment, as illustrated in Fig. 27, a mode switching switch SW is provided in the splicing apparatus 20 so as to be able to set to multiple types (four types) of modes from (1) to (4) described below by the mode switching switch SW.

The first mode is a normal mode in which the vacant cavity portion, the paper portion, and the cavity portion including a component can be detected by the photoelectric sensor 120, and the pitch of the cavities and the starting position of the component are automatically discriminated, thereby deciding the cutting position of the carrier tape T, similarly to the above-described embodiment.

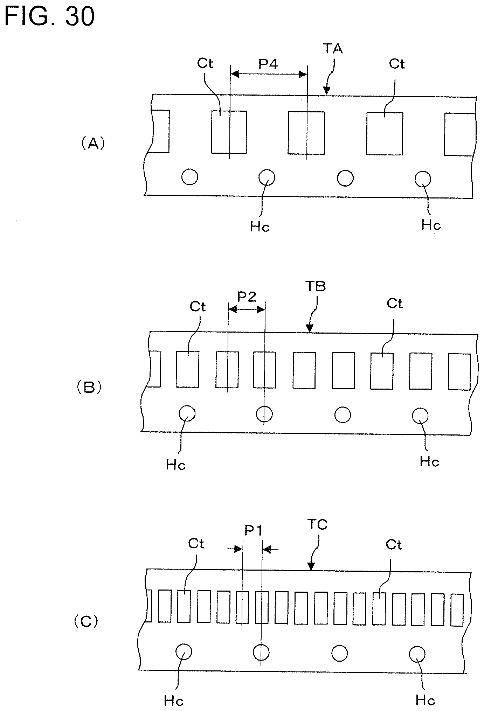

The second, third, and fourth modes are applied to a carrier tape T which cannot automatically discriminate the pitch of the cavities and the starting position of the component. In other words, there are a P4 mode illustrated in Fig. 30 (A) of which the pitch of the cavities is P4 (the same pitch as that of the sprocket hole Hc), a P2 mode illustrated in Fig. 30 (B) of which the pitch of the cavities is P2 (half the pitch of the sprocket hole Hc), and a P1 mode illustrated in Fig. 30(C) of which the pitch of the cavities is P1 (one quarter the pitch of the sprocket hole Hc). In Fig. 3, the components e accommodated in the cavity Ct are omitted.

The mode switching switch SW is set to a normal mode during the normal time, and the pitch of the cavities and the starting position of the component are automatically discriminated based on the output of the photoelectric sensor 120, thereby deciding the cutting position of the carrier tape T.

In contrast, when a carrier tape of which the pitch of the cavities and the starting position of the component cannot be automatically discriminated by the photoelectric sensor 120 is set in the normal mode, since the vacant cavity portion, the paper portion, and the cavity portion including a component cannot be detected even though the carrier tape is fed, a component detection error occurs in the control device 59, and thus, the splicing apparatus 20 is subjected to an emergency stop. Upon the occurrence of the component detection error, a worker determines whether the pitch of the cavities in the carrier tape inserted into the splicing apparatus 20 is P4, P2, or P1, thereby switching the mode switching switch SW in accordance therewith.

Since the control device 59 can recognize the pitch of the cavities in the carrier tape by switching the mode switching switch SW, when the carrier tape is inserted and the photoelectric sensor 120 is shielded from light by the carrier tape, it is possible to know whether there is a carrier tape. Therefore, from the position thereof, in accordance with the pitch of the cavities set by the mode switching switch SW, the carrier tape T can be cut at a predetermined position, and splicing can be automatically executed thereafter.

According to the embodiment, it is possible to automatically connect the different types of the carrier tapes by using the photoelectric sensor 120 which is inexpensive and small.

According to the embodiment, the splicing tape 30a for the front face is fed to a position immediately before the splicing position LS which is detected by the tape detection sensor 48, and the protection tape 31 is fed by the unit distance ΔS0 for N times starting from the position immediately before the splicing position LS until the successive splicing tape 30b for the rear face is detected by the tape detection sensor 48. Thereafter, the protection tape 31 is fed by the certain distance S1, and the splicing tape 30 is positioned at the splicing position LS. Therefore, even though irregularity occurs in pasted positions of the splicing tape 30 with respect to the protection tape 31, the splicing tape 30 can be accurately positioned at the splicing position LS.

According to the above-described embodiment, since the stepping motor 47 rotating the feeding sprocket 46 which engages with the sprocket holes 31a formed in both ends of the protection tape 31 in the width direction returns to the original position when the protection tape 31 starts to be fed, even though a position of the stepping motor 47 is misaligned while the splicing apparatus 20 is halted, it is possible to accurately position the splicing tape 30 at the splicing position LS without being affected by the misalignment.

Moreover, since the engagement tooth 46a of the feeding sprocket 46 includes the dedendum portion 46a1 which engages with the sprocket hole 31a of the protection tape 31 allowing no clearance therebetween, and the sprocket hole 31a of the protection tape 31 engages with the dedendum portion 46a1 by the pressing member 49 allowing no clearance therebetween, the engagement tooth 46a of the feeding sprocket 46 and the sprocket hole 31a of the protection tape 31 can engage with each other with no play therebetween. Accordingly, feeding accuracy of the protection tape 31 can be improved.

According to the above-described embodiment, the protection tape 31 is fed by the unit distance ΔS0 for N times, and then, the protection tape 31 is fed for the certain distance S1. Therefore, regardless of irregularity in pasted positions of the splicing tape 30 with respect to the protection tape 31, the splicing tape 30 can be accurately positioned at the splicing position LS where the splicing tape 30 can engage with the positioning pins 93 and 94.

The unit distance ΔS0 is not limited to a distance corresponding to a tooth of the engagement tooth 46a of the feeding sprocket 46. The unit distance ΔS0 may be a distance corresponding to two teeth or three teeth.

According to the above-described embodiment, the protection tape 31 having the splicing tape 30 pasted is fed by the protection tape feeding device 36 having the stepping motor 47 as a drive source, but the stepping motor 47 can be replaced by a different servo motor.

According to the above-described embodiment, descriptions are given regarding the three-layer structure body including the splicing tape 30, the protection tape 31, and the paper mount 32. However, it is possible to configure a two-layer structure body including the splicing tape 30 and the protection tape 31, omitting the paper mount 32.

According to the above-described embodiment, descriptions are given regarding an example in which metal is embedded in the splicing tapes 30a and 30b, and the splicing tapes 30a and 30b are detected by the tape detection sensor 48 which can detect metal. However, the splicing tape can be detected by a method other than the method of detecting metal.

According to the above-described embodiment, descriptions are given regarding an example in which the two carrier tapes T1 and T2 formed of paper tapes having both of the front face and the rear face to be flat faces are spliced. However, for example, it is possible to splice an embossed tape of which the cavities protrude on the rear face side so as to be irregular.

Moreover, the positioning devices (the first and second tape feeding devices) 50 and 51 for positioning the first and second carrier tapes T1 and T2 at the splicing position LS, the protection tape feeding device 36 for feeding the protection tape 31 in which the splicing tapes 30a and 30b are pasted, and the like are only exemplified configurations which are suitable for executing the present invention. The present invention is not limited to the configuration described in the embodiment.

As described above, the present invention can be applied with various forms without departing from the scope of the present invention disclosed in Claims.

### Reference Signs List

20 ... splicing apparatus; 21 ... device main body; 22 ... lid body; 30 (30a, 30b) ... splicing tape; 31 ... protection tape; 31a ... sprocket hole; 36 ... protection tape feeding device; 46 ... sprocket; 46a ... engagement tooth; 46a1 ... dedendum portion; 47 ... servo motor (stepping motor) ; 48 ... tape detection sensor; 49 ... pressing member; 50, 51 ... positioning device (tape feeding device); 93, 94, 105 ... positioning pin; T1 and T2 ... carrier tape; Hc1, Hc2 ... sprocket hole; Ct1, Ct2 ... cavity; LS ... splicing position

## Claims

1. A splicing tape feeding device in a splicing apparatus (20) in which a first carrier tape (T1) and a second carrier tape (T2) provided with sprocket holes (Hc1, Hc2) and component accommodation cavities (Ct) at regular intervals are fed in a direction approaching each other so as to be positioned at a splicing position (LS), and the first and second carrier tapes (T1, T2) are connected to each other by a splicing tape (30) at the splicing position (LS), the device comprising:
a plurality of the splicing tapes (30a, 30b) that are pasted at the splicing position (LS) at intervals to a continuous protection tape (31) fed in a direction orthogonal to a feeding direction of the first and second carrier tapes (T1, T2) and connect the first and second carrier tapes (T1, T2) to each other;
a protection tape feeding device (36) that feeds the protection tape (31);
a tape detection sensor (48) that detects the splicing tape (30) fed into a position immediately before the splicing position (LS); and
a control device (59) that controls the protection tape feeding device (36) so as to feed the protection tape (31) N times by a unit distance starting from a position at which the tape detection sensor (48) detects the splicing tape (30) until a successive splicing tape (30) is detected by the tape detection sensor (48), to feed the protection tape (31) for a certain distance starting from a position at which the successive splicing tape (30) is detected by the tape detection sensor (48), and to position the splicing tape (30) at the splicing position (LS).

2. The splicing tape feeding device according to Claim 1,
wherein the protection tape feeding device (36) includes a sprocket (46) having engagement teeth (46a) which engage with the sprocket holes (31 a) formed at both ends of the protection tape (31) in a width direction and a servo motor (47) rotating the sprocket (46), and returns to an original position when the servo motor (47) starts to feed the protection tape (31).

3. The splicing tape feeding device according to Claim 2,
wherein the engagement tooth (46a) of the sprocket (46) has a dedendum portion (46a1) which engages with the sprocket hole (31a) of the protection tape (31) while allowing no clearance therebetween and includes a pressing member (49) which presses the protection tape (31) so as to cause the sprocket hole (31a) of the protection tape (31) to engage with the dedendum portion (46a1) allowing no clearance therebetween.

4. The splicing tape feeding device according to any one of Claims 1 to 3,
wherein the unit distance and the certain distance are integer multiples of a pitch of the sprocket hole (31 a) formed in the protection tape (31).

5. The splicing tape feeding device according to any one of Claims 1 to 4,
wherein a positioning hole (30b1) engaging with a positioning pin (93, 94, 105) provided at the splicing position (LS) is formed in the splicing tape (30) so as to penetrate the protection tape (31).

6. A method of feeding a splicing tape (30) in a splicing apparatus (20) in which a first carrier tape (T1) and a second carrier tape (T2) provided with sprocket holes (Hc1, HC2) and component accommodation cavities (Ct) at regular intervals are fed in a direction approaching each other so as to be positioned at a splicing position (LS), and the first and second carrier tapes (T1, T2) are connected to each other by a splicing tape (30) at the splicing position (30), the method comprising:
feeding of a protection tape (31) in which the splicing tape (30) glued across the first and second carrier tapes (T1, T2) which are positioned at the splicing position (LS) is pasted followed by feeding of a splicing tape (30) to the position immediately before the splicing position (LS) detected by a tape detection sensor (48);
feeding of a protection tape (31) performed N times by a unit distance starting from the position immediately before the splicing position (LS) detected by a tape detection sensor (48) until a successive splicing tape (30) is detected by the tape detection sensor (48); and
feeding of the protection tape (31) performed thereafter for a certain distance followed by positioning of the splicing tape (30) at the splicing position (LS).

## Patentansprüche

1. Klebeband-Zuführvorrichtung in einer Verklebe-Einrichtung (20), in der ein erstes Trägerband (T1) und ein zweites Trägerband (T2), die mit Führungslöchern (Hc1, Hc2) und Bauteil-Aufnahmevertiefungen (Ct) in gleichmäßigen Abständen versehen sind, in einer Richtung zugeführt werden, in der sie sich einander nähern, so dass sie an einer Verklebe-Position (LS) positioniert werden, und das erste und das zweite Trägerband (T1, T2) mittels eines Klebebandes (30) an der Verklebe-Position (LS) miteinander verbunden werden, wobei die Vorrichtung umfasst:
eine Vielzahl von Klebebändern (30a, 30b), die an der Verklebe-Position (LS) in Abständen an ein Endlos-Schutzband (31) angeklebt werden, das in einer Richtung im rechten Winkel zu einer Zuführrichtung des ersten und des zweiten Trägerbandes (T1, T2) zugeführt wird, und die das erste und das zweite Trägerband (T1, T2) miteinander verbinden;
eine Schutzband-Zuführvorrichtung (36), die das Schutzband (31) zuführt;
einen Band-Erfassungssensor (48), der das an eine Position unmittelbar vor der Verklebe-Position (LS) zugeführte Klebeband (30) erfasst; und
eine Steuerungsvorrichtung (59), die die Schutzband-Zuführvorrichtung (36) so steuert, dass sie das Schutzband (31) N mal über eine Entfernungseinheit zuführt, die von einer Position, an der der Band-Erfassungssensor (48) das Klebeband (30) erfasst, bis zur Erfassung eines darauffolgenden Klebebandes (30) durch den Band-Erfassungssensor (48) reicht, dass sie das Schutzband (31) über eine bestimmte Entfernung zuführt, die an einer Position beginnt, an der das darauffolgende Klebeband (30) durch den Band-Erfassungssensor (48) erfasst wird, und dass sie das Klebeband (30) an der Verklebe-Position (LS) platziert.

2. Klebeband-Zuführvorrichtung nach Anspruch 1,
wobei die Schutzband-Zuführvorrichtung (36) ein Transportrad (46), das Eingriffs-Zähne (46a) aufweist, die mit den Führungslöchern (31a) in Eingriff kommen, die an beiden Enden des Schutzbandes (31) in einer Breitenrichtung ausgebildet sind, sowie einen Servomotor (47) enthält, der das Transportrad (46) dreht, und sie an eine Ausgangsposition zurückkehrt, wenn der Servomotor (47) beginnt, das Schutzband (31) zuzuführen.

3. Klebeband-Zuführvorrichtung nach Anspruch 2,
wobei der Eingriffszahn (46a) des Transportrades (46) einen Fuß-Abschnitt (46a1) aufweist, der mit dem Führungsloch (31a) des Schutzbandes (31) in Eingriff kommt und dabei keinen Zwischenraum zwischen ihnen zulässt, und ein Presselement (49) enthalten ist, das das Schutzband (31) so presst, dass das Führungsloch (31a) des Schutzbandes (31) mit dem Fuß-Abschnitt (46a1) in Eingriff gebracht wird und kein Zwischenraum zwischen ihnen zugelassen wird.

4. Klebeband-Zuführvorrichtung nach einem der Ansprüche 1 bis 3,
wobei die Entfernungseinheit und die bestimmte Entfernung ganzzahlige Vielfache einer Teilung des Führungslochs (31a) sind, das in dem Schutzband (31) ausgebildet ist.

5. Klebeband-Zuführvorrichtung nach einem der Ansprüche 1 bis 4,
wobei ein Positionier-Loch (30b1), das mit einem Positionier-Zapfen (93, 94, 105) in Eingriff kommt, der sich an der Verklebe-Position (LS) befindet, in dem Klebeband (30) so ausgebildet ist, dass es durch das Schutzband (31) hindurch verläuft.

6. Verfahren zum Zuführen eines Klebebandes (30) in einer Verklebe-Einrichtung (20), in der ein erstes Trägerband (T1) und ein zweites Trägerband (T2), die mit Führungslöchern (Hc1, Hc2) und Bauteil-Aufnahmevertiefungen (Ct) in gleichmäßigen Abständen versehen sind, in einer Richtung zugeführt werden, in der sie sich einander nähern, so dass sie an einer Verklebe-Position (LS) platziert werden, und das erste und das zweite Trägerband (T1, T2) mittels eines Klebebandes (30) an der Verklebe-Position (LS) miteinander verbunden werden, wobei das Verfahren umfasst:
Zuführen eines Schutzbandes (31), in dem das Klebeband (30), das über das erste und das zweite Trägerband (T1, T2) verleimt ist, die an der Verklebe-Position (LS) angeordnet sind, angeklebt wird und anschließend ein Klebeband (30), das durch einen Band-Erfassungssensor (48) erfasst wird, an die Position unmittelbar vor der Verklebe-Position (LS) zugeführt wird;
Zuführen eines Schutzbandes (31), das N mal durchgeführt wird, über eine Entfernungseinheit, die von der Position unmittelbar vor der durch den Band-Erfassungssensor (48) erfassten Verklebe-Position (LS) bis zur Erfassung eines darauffolgenden Klebebandes (30) durch den Band-Erfassungssensor (48) reicht; und
Zuführen des Schutzbandes (31), das danach über eine bestimmte Entfernung durchgeführt wird, vor Platzieren des Klebebandes (30) an der Verklebe-Position (LS).

## Revendications

1. Dispositif d'acheminement de rubans de raccordement dans un appareil de raccordement (20) dans lequel un premier ruban porteur (T1) et un second ruban porteur (T2) dotés, à intervalles réguliers, de perforations d'entraînement (Hcl, Hc2) et de cavités de réception de composant (Ct) sont acheminés dans une direction les rapprochant l'un de l'autre de manière à être positionnés au niveau d'une position de raccordement (LS), et les premier et second rubans porteurs (T1, T2) sont connectés l'un à l'autre par un ruban de raccordement (30) au niveau de la position de raccordement (LS), le dispositif comprenant :
une pluralité de rubans de raccordement (30a, 30b) qui sont collés, par intervalles, au niveau de la position de raccordement (LS), sur un ruban protecteur continu (31) acheminé dans une direction orthogonale à une direction d'acheminement des premier et second rubans porteurs (T1, T2) et qui connectent les premier et second rubans porteurs (T1, T2) l'un à l'autre ;
un dispositif d'acheminement de ruban protecteur (36) qui achemine le ruban protecteur (31) ;
un capteur de détection de ruban (48) qui détecte le ruban de raccordement (30) acheminé à une position immédiatement antérieure à la position de raccordement (LS) ; et
un dispositif de commande (59) qui commande le dispositif d'acheminement de ruban protecteur (36) afin qu'il achemine le ruban protecteur (31) N fois d'une unité de distance, en commençant à une position à laquelle le capteur de détection de ruban (48) détecte le ruban de raccordement (30) jusqu'à ce qu'un ruban de raccordement suivant (30) soit détecté par le capteur de détection de ruban (48), qu'il achemine le ruban protecteur (31) sur une certaine distance en commençant à une position à laquelle le ruban de raccordement suivant (30) est détecté par le capteur de détection de ruban (48), et qu'il positionne le ruban de raccordement (30) au niveau de la position de raccordement (LS).

2. Dispositif d'acheminement de rubans de raccordement selon la revendication 1,
où le dispositif d'acheminement de ruban protecteur (36) inclut un pignon (46) comportant des dents d'engrènement (46a) qui interagissent avec les perforations d'entraînement (31a) formées aux deux extrémités du ruban protecteur (31) dans une direction de la largeur et un servomoteur (47) faisant tourner le pignon (46), et retourne à une position d'origine lorsque le servomoteur (47) commence à acheminer le ruban protecteur (31).

3. Dispositif d'acheminement de rubans de raccordement selon la revendication 2,
où la dent d'entraînement (46a) du pignon (46) comporte une partie en dedendum (46a1) qui interagit avec le perforation d'entraînement (31a) du ruban protecteur (31) en ne permettant aucun dégagement entre eux et qui inclut un organe de pression (49) qui appuye sur le ruban protecteur (31) de manière à faire interagir la perforation d'entraînement (31a) du ruban protecteur (31) avec la partie en dedendum (46a1) sans permettre de dégagement entre eux.

4. Dispositif d'acheminement de rubans de raccordement selon l'une quelconque des revendications 1 à 3,
où l'unité de distance et la certaine distance sont des multiples entiers d'un pas de la perforation d'entraînement (31a) formée dans le ruban protecteur (31).

5. Dispositif d'acheminement de rubans de raccordement selon l'une quelconque des revendications 1 à 4,
où un trou de positionnement (30b1) interagissant avec une broche de positionnement (93, 94, 105) prévue au niveau de la position de raccordement (LS) est formé dans le ruban de raccordement (30) de manière à pénétrer le ruban protecteur (31).

6. Procédé d'acheminement d'un ruban de raccordement (30) dans un appareil de raccordement (20) dans lequel un premier ruban porteur (T1) et un second ruban porteur (T2) dotés, à intervalles réguliers, de perforations d'entraînement (Hc1, Hc2) et de cavités de réception de composant (Ct) sont acheminés dans une direction les rapprochant l'un de l'autre de manière à être positionnés au niveau d'une position de raccordement (LS), et le premier et le second ruban porteur (T1, T2) sont connectés l'un à l'autre par un ruban de raccordement (30) au niveau de la position de raccordement (LS), le procédé comprenant les étapes consistant à :
acheminer un ruban protecteur (31) sur lequel est collé le ruban de raccordement (30) collé en travers des premier et second rubans porteurs (T1, T2) qui sont positionnés au niveau de la position de raccordement (LS), suivi de l'acheminement d'un ruban de raccordement à la position immédiatement antérieure à la position de raccordement (LS) détectée par le capteur de détection de ruban (48) ;
acheminer un ruban protecteur (31) N fois d'une unité de distance, en commençant à la position immédiatement antérieure à la position de raccordement (LS) détectée par un capteur de détection de ruban (48) jusqu'à ce qu'un ruban de raccordement suivant (30) soit détecté par le capteur de détection de ruban (48) ; et
acheminer ensuite le ruban protecteur (31) sur une certaine distance suivi par le positionnement du ruban de raccordement (30) au niveau de la position de raccordement (LS).
